Europäisches Patentamt

European Patent Office

Office européen des brevets

(11) Veröffentlichungsnummer: **0 141 427**
**B1**

(12) EUROPÄISCHE PATENTSCHRIFT

(45) Veröffentlichungstag der Patentschrift: **26.09.90**

(21) Anmeldenummer: **84113452.1**

(22) Anmeldetag: **07.11.84**

(51) Int. Cl.⁵: **H 03 K 17/10,** H 03 K 17/04,
H 01 J 23/065

(54) Gitterimpulsmodulator für eine mit einem Steuergitter ausgerüstete Hochleistungs-Wanderfeldröhre.

(30) Priorität: **09.11.83 DE 3340546**

(43) Veröffentlichungstag der Anmeldung:
**15.05.85 Patentblatt 85/20**

(45) Bekanntmachung des Hinweises auf die
Patenterteilung:
**26.09.90 Patentblatt 90/39**

(84) Benannte Vertragsstaaten:
**BE DE FR GB IT NL**

(56) Entgegenhaltungen:
DE-A-3 230 080
US-A-3 636 476
US-A-3 639 784
US-A-4 454 430

ELECTRONIC DESIGN, Band 30, Nr. 15, 22. Juli
1982, Seiten 170, 172, Waseca, Mn, Denville, NJ,
US; P.N. WOOD: "MOSFET switch driver
maintains transformer-coupled pulse
waveform"

(73) Patentinhaber: **Siemens Aktiengesellschaft**
**Wittelsbacherplatz 2**
**D-8000 München 2 (DE)**

(72) Erfinder: **Meissner, Harald, Ing. grad.**
**Weiherstrasse 14**
**D-8039 Puchheim (DE)**

Courier Press, Leamington Spa, England.

**Beschreibung**

Die Erfindung bezieht sich auf einen Gitterimpulsmodulator für eine mit einem Steuergitter ausgerüstete Hochleistungs-Wanderfeldröhre, deren Röhrenstrom-gesteuert über eine impulsgesteuerte Schalteinrichtung - wechselweise mittels einer das Steuergitter beaufschlagenden, gegenüber dem Kathodenpotential positiven Tastspannung während der Hochfrequenz-Impulsverstärkung freigegeben und mittels einer ebenfalls das Steuergitter beaufschlagenden, gegenüber dem Kathodenpotential negativen Sperrspannung während der Impulspausen gesperrt wird.

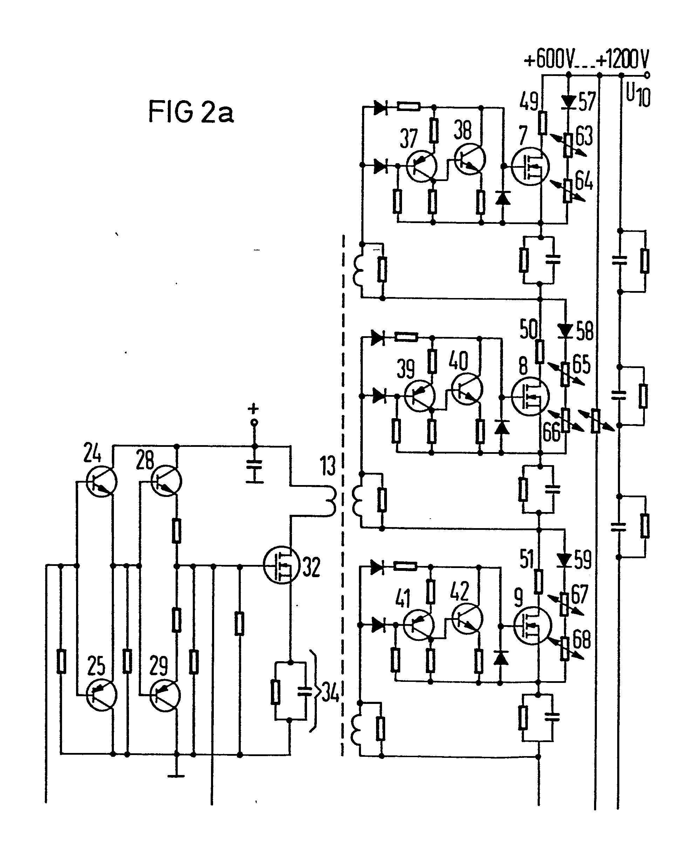

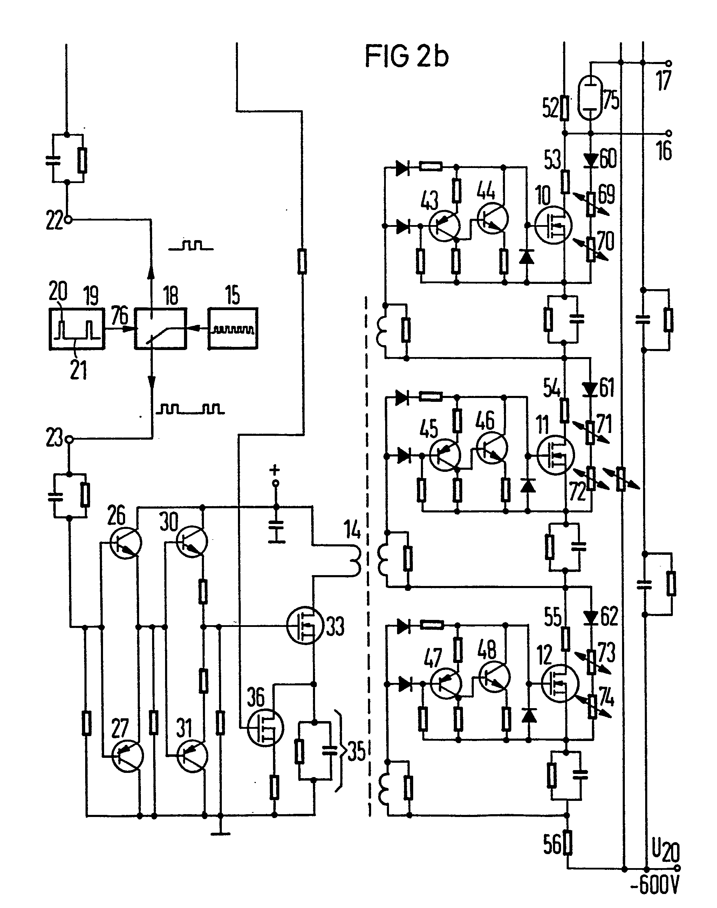

Aus dem Beitrag von P.N. Wood: "MOSFET switch driver maintains transformer-coupled pulse waveform" in der Zeitschrift "Electronic Design", Vol. 30, No. 15, Juli 1982, Seiten 170, 172, insbesondere Fig. 2 und deren Beschreibung, ist eine impulsgesteuerte Schalteinrichtung bekannt, die aus einer Reihenschaltung von Leistungs-MOSFETs besteht und bei der die Ansteuerung der einzelnen Stufen mit Impulsen über Übertrager erfolgt. Mit dieser Schalteinrichtung werden jedoch keine Tastspannungen und Sperrspannungen auf das Steuergitter einer Wanderfeldröhre durchgeschaltet.

Moderne Hochleistungs-Wanderfeldröhren für Impulsbetrieb sind mit einem Steuergitter ausgerüstet, das den Strom der Röhre während der Verstärkung der Hochfrequenz-Trägerimpulse freigibt und während der Impulspausen sperrt. Bekannt ist eine solche Wanderfeldröhre für Impulsbetrieb für den Einsatz in einem Pulsradarsender z.B. aus dem "Handbuch für Hochfrequenz- und Elektro-Techniker" von C. Rint, Band 4, 10. Auflage, 1980, Seiten 596-598.

Bei den handelsüblichen getasteten Wanderfeldröhren betragen die Tastspannung am Gitter z.B. +600 ... +1200 V und die Sperrspannung am Gitter z.B. −600 V gegenüber dem Kathodenpotential. Der Gittermodulator muß also das Gitter der Wanderfeldröhre um etwa 1 ... 2 kV in der Nähe des Kathodenpotentials hin- und hertasten. Da die Kathode gegenüber der Anode eine Spannung von 30 ... 60 kV haben muß und die Anode der Röhre zumeist an Masse gelegt ist, kann zwischen der Ansteuerung, die auch an Masse liegt, und dem Ausgang des Gittermodulators, der das Gitter schaltet, eine Spannung von 30 ... 60 kV auftreten. Der Gittermodulator liegt somit auf dem Kathodenpotential der Wanderfeldröhre, so daß zwischen der Ansteuerung des Gitterimpulsmodulators und dem Modulator selbst bis zu 60 kV auftreten können. Die Schaltzeit von der Sperrung der Röhre bis zu deren Entsperrung und umgekehrt soll kleiner als 500 nsec sein. Die Gitterkathodenkapazität der Röhren beträgt ca. 150 ... 200 pF und der Gitterstrom während des Anlegens der Tastspannung am Gitter maximal ± 50 mA.

Aufgabe der Erfindung ist es, den Gitterimpulsmodulator der eingangs genannten Art so auszubilden, daß die durch das Wechselspiel zwischen Sperrung und Entsperrung der Röhre entstehende Impulsfolge von der jeweiligen Impulsbreite und Impulsfolgedauer weitestgehend unabhängig ist. Der Gittermodulator soll sich somit möglichst universell einsetzen lassen. Möglich sein soll beispielsweise eine Impulsbreite $\lesssim 2$ μsec und ein Verhältnis Impulsbreite/Impulsabstamd $\leqq 95\%$. Dabei sollen in allen Fällen sehr kurze Anstiegs- und Abfallzeiten an den Impulsflanken sowie ein sauberes Impulsdach erreicht werden.

Gemäß der Erfindung wird diese Aufgabe dadurch gelöst, daß die Schalteinrichtung sowohl zur Durchschaltung der Tastspannung als auch der Sperrspannung jeweils eine Reihenschaltung aus mehreren Leistungs-Feldeffekt-Transistoren aufweist, deren eines Ende jeweils am Gitteranschluß der Wanderfeldröhre und deren anderes Ende am positiven Anschluß einer Tastspannungsquelle bzw. am negativen Anschluß einer Sperrspannungsquelle liegt, daß zur Ansteuerung jeder der beiden Leistungs-Feldeffekt-Transistorreihenschaltungen ein eigener Ringkernübertrager vorgesehen ist, der auf der Sekundärseite für jede Leistungs-Feldeffekt-Transistorstufe eine eigene Wicklung aufweist und an dessen Primärseite eine Beaufschlagung mit unipolaren, hochfrequenten Impulsen derart erfolgt, daß der der Reihenschaltung der für die Tastung zuständigen Feldeffekt-Transistoren zugeordnete Ringkernübertrager jeweils während der Dauer der Gittertastimpulse und der andere Ringkernübertrager während der Dauer der Gitterimpulspausen eine Kette von gleichartigen, unipolaren Hochfrequenz-Spannungsimpulsen erhält, welche die Feldeffekt-Transistoren der jeweils beaufschlagten Reihenschaltung in den leitenden Zustand versetzen, daß zu Beginn einer Hochfrequenz-Spannungsimpulskette der erste Impuls davon die Eingangskapazität der Feldeffekt-Transistoren der jeweils beaufschlagten Reihenschaltung auflädt und daß bei jedem Feldeffekt-Transistor eine speziell dimensionierte RC-Entladeschaltung mit Transistoren vorgesehen ist, welche die Eingangskapazität so langsam entlädt, daß die jeweiligen Feldeffekt-Transistoren beim Eintreffen des jeweils nächsten Hochfrequenz-Spannungsimpulses noch leitend sind.

In vorteilhafter Weise wird beim Umschalten von der Tastspannung auf die Sperrspannung und umgekehrt jeweils der letzte vor dem Umschaltvorgang eintreffende Hochfrequenzimpuls für die jeweils noch durchgeschaltete Transistor-Reihenschaltung unterdrückt. Die Feldeffekttransistoren der dann nicht mehr benötigten Transistor-Reihenschaltung werden damit zum Zeitpunkt der Gitterimpulsflanke rechtzeitig und betriebssicher gesperrt, da die zur Entladung der Eingangskapazitäten der Transistoren zur Verfügung stehende Zeit ausreicht, um diese Sperrung zu gewährleisten.

Ein Vorteil der Schaltung besteht darin, daß zur Ansteuerung der Feldeffekt-Schalttransistoren auf der 60 kV-Seite keine zusätzlichen Betriebsspannungen erforderlich sind. Die verhältnismäßig geringe Ansteuerleistung, welche die Feldeffekttransistoren benötigen, läßt sich über die Ringkerntransformatoren übertragen.

Die positive Tastspannung und die negative Sperrspannung sind hinsichtlich ihrer Größe an die geforderten Werte der jeweils verwendeten Wanderfeldröhre anzupassen. Eine Anpassung der Modulatorschaltung nach der Erfindung an diese zu schaltenden Gitterspannungswerte der Wanderfeldröhre ist dadurch möglich, daß die Zahl der Schalttransistoren in jeder der beiden Feldeffekt-Transistorreihenschaltungen variiert werden kann.

Zweckmäßige und vorteilhafte Weiterbildungen der Erfindung sind in den Unteransprüchen ausgeführt.

Die Erfindung wird im folgenden anhand von zwei Figuren erläutert.

Es zeigen

Fig. 1 das Prinzipschaltbild für die Impulsansteuerung einer mit einem Gitter ausgerüsteten Wanderfeldröhre und

Fig. 2 ein Ausführungsbeispiel für eine Schaltung eines Gitterimpulsmodulators nach der Erfindung. Fig. 2 besteht aus Platzgründen aus Fig. 2a und Fig. 2b. Zur Betrachtung der Gesamtfigur ist Fig. 2a oben an Fig. 2b anzusetzen, wobei die jeweils fünf offenen Linien zueinander fluchten.

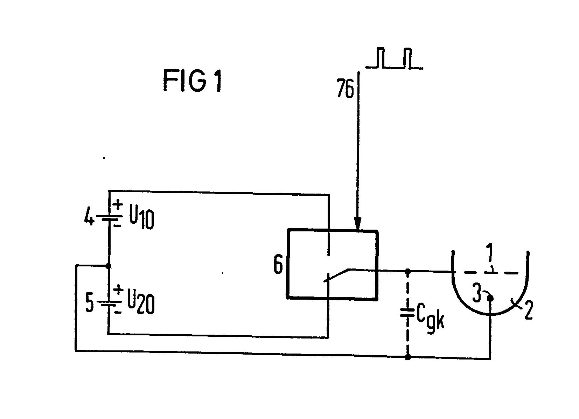

Das Prinzipschaltbild in Fig. 1 zeigt eine mit einem Steuergitter 1 ausgerüstete Hochleistungs-Wanderfeldröhre 2 für Impulsbetrieb. Die Kathode 3 der mit der Anode an Masse geschalteten Wanderfeldröhre 2 liegt auf einem Potential von z.B.-60 kV. Das Steuergitter 1 soll den Strom der Röhre während der Verstärkung der hochfrequenten Trägerimpulse freigeben und während der Impulspausen sperren. Zur Erzeugung der Tastspannung $U_{10}$ und der Sperrspannung $U_{20}$ dienen zwei Gleichspannungsquellen 4 und 5. Bei den handelsüblichen getasteten Wanderfeldröhren betragen die Tastspannung $U_{10}$ etwa +600 bis +1200 V und die Sperrspannung $U_{20}$ ca. −600 V. Die Schaltzeit von der Sperrung der Röhre 2 bis zur Entsperrung und umgekehrt soll kleiner als 500 nsec sein. Die Gitterkathodenkapazität $C_{gk}$ der Wanderfeldröhren beträgt etwa 150-200 pF und der Gitterstrom während des Anlegens der Tastspannung $U_{10}$ am Gitter 1 maximal ± 50 mA. Dieser Maximalwert von ± 50 mA gilt nur für den eingeschwungenen Zustand. Während der Umschaltflanken fließen durch das Umladen der Gitterkapazität bedingte Gitterströme von einigen Ampère, je nach Steilheit der Flanken. Der eigentliche Gittermodulator, der als Schalter 6 dargestellt ist, liegt auf dem Kathodenpotential der Wanderfeldröhre 2, so daß zwischen der Ansteuerung 76 dieses Modulators und dem Modulator selbst bis zu 60 kV auftreten können. Die Tastspannung $U_{10}$ und die Sperrspannung $U_{20}$ werden auf Kathodenebene erzeugt, so daß der negative Pol der Tastspannungsquelle 4 und der positive Pol der Sperrspannungsquelle 5 mit der Kathode 3 verbunden sind. Der als gesteuerter Schalter 6 ausgeführte Gittermodulator schaltet abwechselnd eine der beiden Spannungen $U_{10}$ und $U_{20}$ an das Gitter 1 durch, und zwar je nach dem, ob am Ansteuereingang 76 ein Impuls oder eine Impulspause vorliegt.

Fig. 2 zeigt die Schaltung eines Ausführungsbeispiels des als Schalter 6 ausgeführten Gittermodulators nach Fig. 1. Jede der Schaltstrecken dieses Schalters besteht aus der Reihenschaltung von z.B. drei Leistungs-Feldeffekt-Transistoren. Die Feldeffekt-Transistoren zur Durchschaltung der Impulse, d.h. der Tastspannung $U_{10}$, sind mit 7, 8, 9 und die Feldeffekttransistoren zur Durchschaltung der Impulspausen, d.h. der negativen Sperrspannung $U_{20}$, mit 10, 11, 12 bezeichnet. Im Sperrzustand wird jede Schaltstrecke mit bis zu 1800 V beansprucht. Die Ansteuerung der Transistoren 7, 8 und 9 erfolgt über einen Ringkernübertrager 13 und die Ansteuerung der Transistoren 10, 11 und 12 über einen anderen Ringkernübertrager 14. Jede Wicklung der Ringkernübertrager 13 und 14 hat nur zwei Windungen und ist in Hochspannungslitze ausgeführt. Die Übertrager 13 und 14 sind zusammen mit dem Modulator und den zugehörigen Spannungsquellen 4 und 5 (siehe Fig. 1) zur Erzeugung der Gittervorspannungen $U_{10}$ und $U_{20}$ in Isolierflüssigkeit angeordnet, wodurch die erforderliche Spannungsfestigkeit gut eingehalten wird. Die Isolation der Ringkernübertragerwicklungen muß allerdings nicht unbedingt in Isolierflüssigkeit erfolgen. Es läßt sich beispielsweise auch Gießharz verwenden.

Die Ansteuerung der Feldeffekt-Transistoren 7 bis 12 erfolgt durch eine Kette von unipolaren Hochfrequenz-Spannungsimpulsen, die in einem Hochfrequenz-Impulsgenerator 15 erzeugt werden. Die Breite eines Hochfrequenz-Spannungsimpulses beträgt beispielsweise etwa 125 nsec. Um die Sperrspannung $U_{20}$ von etwa −600 V an den mit dem Gitter der Wanderfeldröhre verbundenen Ausgang 16 der Schaltung zu legen, wird die untere, aus den Transistoren 10 bis 12 bestehende Transistorkette mit einer ununterbrochenen Folge dieser Hochfrequenz-Spannungsimpulse angesteuert.

Die Eingangskapazität jedes der Transistoren 10 bis 12 wird dabei beim ersten Impuls aufgeladen und durch eine speziell dimensionierte Entladeschaltung so langsam entladen, daß die Transistoren 10 bis 12 beim Eintreffen des nächsten Hochfrequenz-Spannungsimpulses noch leitend sind. Auf diese Weise beträgt die Restwelligkeit, die durch die taktsynchronen Hochfrequenz-Spannungsimpulse auf der an der Röhre liegenden Gitterspannung hervorgerufen wird, allerhöchstens noch 3 bis 5 %.

Zum Durchschalten eines Gitterimpulses werden die Hochfrequenz-Spannungsimpulse von der unteren Transistorkette mit den Transistoren 10 bis 12 weggenommen und ebensolche Hochfrequenz-Spannungsimpulse an die obere, aus den Transistoren 7 bis 9 bestehende Transistorkette gegeben. Damit die untere Transistorkette vom leitenden Zustand in den Sperrzustand übergeht, muß zunächst die Eingangskapazität jedes der Transistoren 10 bis 12 entladen werden. Diese Entladung wird mit Rücksicht auf den gewünschten geringen Störspannungsanteil an der Modulatorausgangsspannung so langsam vorgenommen, daß die Transistoren 10 bis 12 nach einem Hochfrequenz-Spannungsimpuls zum Zeitpunkt des nächsten Hochfrequenz-Spannungsimpulses noch leitend sind. Der kontinuierliche Fluß von Hochfrequenz-Spannungsimpulsen wird deshalb zum Zeitpunkt der Gitterimpulsflanken in der Weise unterbrochen, daß zur betriebssicheren Sperrung der Schalttransistoren 10 bis 12 der dann nicht mehr benötigten Transistorkette jeweils der letzte zugehörige Hochfrequenz-Ansteuerspannungsimpuls vor der Gitterimpulsflanke weggelassen wird. Die Zeit, die dadurch zur Entladung der Eingangskapazitäten der Transistoren 10 bis 12 zur Verfügung steht, reicht aus, um die rechtzeitige Sperrung zu gewährleisten.

Soll von einem Gitterimpuls wieder auf eine Impulspause umgeschaltet werden, so werden die Hochfrequenz-Spannungs impulse von der oberen, aus den Transistoren 7 bis 9 bestehenden Transistorkette weggenommen und gleichartige Hochfrequenz-Spannungsimpulse wieder an die untere, aus den Transistoren 10 bis 12 bestehende Transistorkette gegeben. Auch hier müssen die Transistoren, in diesem Fall sind es die Transistoren 7 bis 9 vom leitenden Zustand in den Sperrzustand gelangen, wobei zunächst die Eingangskapazität der Transistoren 7 bis 9 entladen werden muß. Auch hier wird die Entladung mit Rücksicht auf den gewünschten geringen Störspannungsanteil auf der Modulatorausgangsspannung so langsam vorgenommen, daß die Transistoren 7 bis 9 nach einem Hochfrequenz-Spannungsimpuls zum Zeitpunkt des nächsten Hochfrequenz-Spannungsimpulses noch leitend sind. Der kontinuierliche Fluß von Hochfrequenz-Spannungsimpulsen wird somit auch beim Übergang von einem Impuls auf eine Impulspause zum Zeitpunkt der Gitterimpulsflanken in der Weise unterbrochen, daß zur betriebssicheren Sperrung der Schalttransistoren 7 bis 9 der oberen, dann nicht mehr benötigten Transistorkette jeweils der letzte zugehörige Hochfrequenz-Ansteuerimpuls vor der Gitterimpulsflanke weggelassen wird. Auch hier reicht die dadurch zur Entladung der Eingangskapazitäten der Transistoren 7 bis 9 gewonnene Zeit aus, um die rechtzeitige Sperrung der Transistoren 7 bis 9 zu gewährleisten.

Die Kathode der Wanderfeldröhre liegt auf einem Potential von etwa 60 kV und ist an den Ausgang 17 der Schaltung nach Fig. 2 angeschlossen. Ein Vorteil der Schaltung besteht darin, daß zur Ansteuerung der Schalttransistoren 7 bis 12 auf der 60 kV-Seite keine zusätzlichen Betriebsspannungen erforderlich sind. Die verhältnismäßig geringe Ansteuerleistung, welche die Leistungs-Feldeffekt-Transistoren 7 bis 12 benötigen, läßt sich über die Ringkerntransformatoren 13 und 14 übertragen.

Die Hochfrequenz-Spannungsimpulse werden in einem Hochfrequenz-Impulsgenerator 15 erzeugt und an einen Umschalter 18 weitergeleitet. Dieser Umschalter 18 wird über einen Steuereingang 76 (identisch mit dem Steuereingang 76 in Fig. 1) von einem Impulsgenerator 19 gesteuert, welcher die Längen der vom Gittermodulator abzugebenden Impulse 20 und der Impulspausen 21 dazwischen festlegt. Während der Impulse 20 liegt der Durchschaltweg des Umschalters 18 am Eingang 22 der Ansteuerschaltung für die Transistorkette mit den Transistoren 7, 8 und 9. Während der Impulspausen 21 verläuft der Durchschaltweg des Umschalters 18 zum Eingang 23 der anderen Ansteuerschaltung, welche die drei Transistoren 10 bis 12 beaufschlagt. Somit werden die Hochfrequenz-Spannungsimpulse während der Pulse 20 an den Eingang 22 und während, der Impulspausen 21 an den Eingang 23 geleitet. Wie vorstehend bereits beschrieben worden ist, wird jeweils der letzte zugehörige Hochfrequenz-Spannungsimpuls vor einer Gitterimpulsflanke weggelassen.

Die beiden Ansteuerschaltungen für die beiden aus den Transistoren 7 bis 9 bzw. 10 bis 12 bestehenden Transistor ketten sind im Prinzip gleich. Die den Eingängen 22 bzw. 23 zugeführten Hochfrequenz-Spannungsimpulse steuern die erste Stufe aus npn-pnp-Transistoren 24, 25 bzw. 26, 27. Die zweite Stufe, die ebenfalls jeweils aus zwei npn-pnp-Transistoren 28, 29 bzw. 30, 31 besteht, kann bereits eine erheblich höhere Stromstärke, z.B. etwa 500 mA, liefern. Das genügt, um den Endtransistor 32 bzw. 33 jeder der Ansteuerschaltungen schnell genug anzusteuern. Die RC-Kombination 34 bzw. 35 zwischen dem Source-Anschluß der Transistoren 32 bzw. 33 und Masse bewirkt, daß jeweils nur der erste übertragene Hochfrequenz-Spannungsimpuls einer Folge mit der maximalen Amplitude an die beiden Transistorketten 7 bis 9 bzw. 10 bis, 12 gegeben wird. Die Amplituden der folgenden Hochfrequenz-Spannungsimpulse nehmen ab bis auf einen viel kleineren Wert, der zur Aufrechterhaltung der Durchschaltung der jeweiligen Transistorkette reicht. Die große Amplitude des ersten Hochfrequenz-Spannungsimpulses wird benötigt, um mit der Transistorkette die Umschaltflanke des Gitterimpulses mit der gewünschten Steilheit zu schalten und damit die Gitter-Kathoden-Kapazität $C_{gk}$ der Wanderfeldröhre aus reichend schnell umzuladen.

In der Ansteuerschaltung für die Gitter-Impulspause ist ein Feldeffekt-Transistor 36 zur Entladung der RC-Kombination 35 vorgesehen. Da die eigene Entladung länger dauert als ein kurzer Gitterimpuls 20, würde ohne aktive Entladung dieser RC-Kombination 35 die Umschaltflanke am Ende des kurzen Gitterimpulses 20 nicht mit der erforderlichen Steilheit ausgeführt werden.

Die Schalttransistoren 7 bis 9 bzw. 10 bis 12 jeweils einer der beiden Transistorketten werden schlagartig vom ersten Hochfrequenz-Stromimpuls, der eine größere Amplitude aufweist als die nachfolgenden Hf-Impulse, leitend gesteuert. Durch die große Eingangskapazität der Transistoren 7 bis 9 bzw. 10 bis 12 bleibt dieser Zustand länger erhalten. Zur wohldosierten Entladung dienen in jedem Eingangskreis der Transistoren 7 bis 12, angeordnete pnp-npn-Transistoren 37 bis 48, die leitend werden, sobald kein Hochfrequenz-Eingangsimpuls mehr anliegt.

Der in einem Ausführungsbeispiel in Fig. 1 dargestellte Modulator nach der Erfindung ist durch verschiedene Maßnahmen gegen Überspannungen, Kurzschlußströme usw. geschützt. Damit eine sichere Spannungsfestigkeit von 60 kV gegen Masse erreicht wird, erfolgt die Trennung der 60 kV durch die beiden Ringkernübertrager 13 und 14, die mit Hochspannungslitze bewickelt sind. Beide Übertrager 13 und 14 und die auf 60 kV liegende Schaltung sind in diesem Ausführungsbeispiel in einer Isolierflüssigkeit in einem Rahmen, der als Faraday'scher Käfig wirkt, untergebracht. Direkt an den Kathoden und Gitteranschlüssen der Wanderfeldröhre ist ein Überspannungsableiter von z.B. 1400 V Nennspannung (Ansprechspannung) angeordnet. Dieser Überspannungsableiter hat eine deutlich geringere Ansprechspannung als die zulässige Sperrspannung einer Feldeffekt-Transistorreihenschaltung 7 bis 9 bzw. 10 bis 12. Diese beiden Reihenschaltungen sind so ausgelegt, daß sie jeweils 2 kV Sperrspannung vertragen, da 1800 Volt anliegen. Der Überspannungsableiter zwischen Kathode und Gitter der Wanderfeldröhre hat im Ausführungsbeispiel eine Ansprechspannung von 1400 V, da maximal 1200 Volt Gitterspannung gegenüber dem Kathodenpotential benötigt werden. Die Differenz zwischen 1400V und 2 kV, d.h. 600 V, kommen der Sicherheit der beiden Feldeffekt-Transistorreihenschaltungen zugute.

Um eine hohe Sicherheit gegen Röhrenüberschläge zu erreichen, liegen in jedem der beiden mit den Transistoren 7 bis 9 bzw. 10 bis 12 versehenen Transistorkreisen vier niederohmige Reihenwiderstände 49 bis 56. Dadurch wird im Bereich bis 2 kV der Strom auf 10 A begrenzt. Am Ausgang 16 des Modulators liegt in zweckmäßiger Weise ebenfalls ein Überspannungsableiter 75 mit einer Nennspannung von beispielsweise 1400 V. Dadurch werden von der Röhrenseite kommende Überspannungen auf unschädliche Werte begrenzt. Jede der beiden Transistorketten 7 bis 9 und 10 bis 12 kann bis zu 2,5 kV sperren. Damit diese Sperrspannung gleichmäßig auf die jeweils drei Transistoren 7 bis 9 bzw. 10 bis 12 aufgeteilt wird, ist parallel zu jedem dieser Transistoren eine Reihenschaltung angeordnet, die aus einem schnellen Gleichrichter 57 bis 62 und zwei Varistoren 63 bis 74 besteht.

Die dargestellte Schaltung läßt sich beispielsweise als Pulsmodulator für eine Hochleistungs-Wanderfeldröhre in einem Pulsradarsender verwenden.

## Patentansprüche

1. Gitterimpulsmodulator für eine mit einem Steuergitter ausgerüstete Hochleistungs-Wanderfeldröhre, deren Röhrenstrom — gesteuert über eine impulsgesteuerte Schalteinrichtung — wechselweise mittels einer das Steuergitter beaufschlagenden, gegenüber dem Kathodenpotential positiven Tastspannung während der Hochfrequenz-Impulsverstärkung freigegeben und mittels einer ebenfalls das Steuergitter beaufschlagenden, gegenüber dem Kathodenpotential negativen Sperrspannung während der Impulspausen gesperrt wird, dadurch gekennzeichnet, daß die Schalteinrichtung sowohl zur Durchschaltung der Tastspannung ($U_{10}$) als auch der Sperrspannung ($U_{20}$) jeweils eine Reihenschaltung aus mehreren Leistungs-Feldeffekt-Transistoren (7, 8, 9 bzw. 10, 11, 12) aufweist, deren eines Ende jeweils am Gitteranschluß (16) der Wanderfeldröhre und deren anderes Ende am positiven Anschluß einer Tastspannungsquelle (4) bzw. am negativen Anschluß einer Sperrspannungsquelle (5) liegt, daß zur Ansteuerung jeder der beiden Leistungs-Feldeffekt-Transistorreihenschaltungen ein eigener Ringkernübertrager (13, 14) vorgesehen ist, der auf der Sekundärseite für jede Leistungs-Feldeffekt-Transistorstufe eine eigene Wicklung aufweist und an dessen Primärseite eine Beaufschlagung mit unipolaren, hochfrequenten Impulsen derart erfolgt, daß der der Reihenschaltung der für die Tastung zuständigen Feldeffekt-Transistoren zugeordnete Ringkernübertrager (13) jeweils während der Dauer der Gittertastimpulse und der andere Ringkernübertrager (14) während der Dauer der Gitterimpulspausen eine Kette von gleichartigen, unipolaren Hochfrequenz-Spannungsimpulsen erhält, welche die Feldeffekt-Transistoren der jeweils beaufschlagten Reihenschaltung in den leitenden Zustand, versetzen, daß zu Beginn einer Hochfrequenz-Spannungsimpulskette der erste Impuls davon die Eingangskapazität der, Feldeffekt-Transistoren der jeweils beaufschlagten Reihenschaltung auflädt und daß bei jedem Feldeffekt-Transistor eine speziell dimensionierte RC-Entladeschaltung mit Transistoren vorgesehen ist, welche die Eingangskapazität so langsam entlädt, daß die jeweiligen Feldeffekt-Transistoren beim Eintreffen des jeweils nächsten Hochfrequenz-Spannungsimpulses noch leitend sind.

2. Gitterimpulsmodulator nach Anspruch 1, dadurch gekennzeichnet, daß beim Umschalten von der Tastspannung ($U_{10}$) auf die Sperrspannung ($U_{20}$) und umgekehrt jeweils der letzte vor dem Umschaltvorgang eintreffende Hochfrequenzimpuls für die jeweils noch durchgeschaltete Transistorkette (7 bis 9 bzw. 10 bis 12) unterdrückt wird.

3. Gitterimpulsmodulator nach Anspruch 1 oder 2, dadurch gekennzeichnet, daß auf der Primärseite der beiden Ringkernübertrager (13, 14) die Hochfrequenzimpulse jeweils über eine Transistorverstärkerschaltung (24, 25, 28, 29, 32 bzw. 26, 27, 30, 31, 33) geführt sind, die im Primärwicklungskreis in Reihe zur Durchschaltstrecke eines von dieser Transistorverstärkerschaltung angesteuerten Feldeffekt-Endtransistors (32, 33) eine RC-Kombination (34, 35) aufweist, die dafür sorgt, daß jeweils nur der erste nach einem Umschaltvorgang von Impulspause auf Impuls bzw. von Impuls auf Impulspause übertragene Hochfrequenzimpuls mit einer maximalen Amplitude an die jeweilige Transistorreihenschaltung (7, 8, 9 bzw. 10, 11, 12) gegeben wird.

4. Gitterimpulsmodulator nach Anspruch 3, dadurch gekennzeichnet, daß in der für die Durchschaltung der Sperrspannung ($U_{20}$) zuständigen Transistorverstärkerschaltung (26, 27, 30, 31, 33) Parallel zur RC-Kombination (35) die, Drain-Source-Strecke eines weiteren Feldeffekt-Transistors (36) liegt, dessen Gate-Elektrode mit der Gate-Elektrode desjenigen Feldeffekt-Endtransistors zusammengeschaltet ist, welcher der Transistorverstärkerschaltung (24, 25, 28, 29, 32) zur Durchschaltung der Tastspannung ($U_{20}$) angehört.

5. Gitterimpulsmodulator nach einem der vorhergehenden Ansprüche, dadurch gekennzeichnet, daß die beiden Ringkernübertrager (13, 14) mit Hochspannungslitze bewickelt sind.

6. Gitterimpulsmodulator nach einem der vorhergehenden Ansprüche, gekennzeichnet durch eine Unterbringung in einem als Faraday'scher Käfig wirkenden Metallrahmen, der mit Isolierflüssigkeit gefüllt ist.

7. Gitterimpulsmodulator nach einem der vorhergehenden Ansprüche, dadurch gekennzeichnet, daß direkt an den Gitter- und Kathodenanschlüssen der Wanderfeldröhre ein Überspannungsableiter angeordnet ist.

8. Gitterimpulsmodulator nach einem der vorhergehenden Ansprüche, dadurch gekennzeichnet, daß zur Strombegrenzung in jeder der beiden Transistorketten (7 bis 9, 10 bis 12) ein oder mehrere niederohmige Widerstände (49 bis 56) eingeschaltet sind.

9. Gitterimpulsmodulator nach einem der vorhergehenden Ansprüche, dadurch gekennzeichnet, daß zur Sicherheit gegen Überschläge der Wanderfeldröhre am Modulatorausgang (16) ein Überspannungsableiter (75) angeordnet ist.

10. Gitterimpulsmodulator nach einem der vorhergehenden Ansprüche, dadurch gekennzeichnet, daß zur gleichmäßigen Verteilung der Sperrspannung auf die einzelnen Transistoren (7 bis 12) der Transistorketten parallel zur Drain-Source-Strecke jedes Transistors eine aus einem schnellen Gleichrichter (57 bis 62) und einem oder mehreren Varistoren (63 bis 74) bestehende Reihenschaltung vorgesehen ist.

**Revendications**

1. Modulateur d'impulsions de grille pour un tube à ondes progressives de grande puissance équipé d'une grille de commande, le courant du tube étant alternativement libéré d'une manière commandée par l'intermédiaire d'un dispositif de commutation commandé par impulsions- à l'aide d'une tension de commande chargeant la grille de commande et positive par rapport au potentiel de la cathode, pendant l'amplification des impulsions à haute fréquence, et bloqué au moyen d'une tension de blocage, qui charge également la grille de commande et est négative par rapport au potentiel de la cathode, pendant les pauses entre impulsions, caractérisé par le fait que le dispositif de commutation contient pour la transmission aussi bien de la tension de libération ($U_{10}$) que de la tension de blocage ($U_{20}$), respectivement un circuit série formé de plusieurs transistors à effet de champ de puissance (7, 8, 9 ou 10, 11, 12), dont une extrémité est raccordée respectivement à la borne de grille (16) du tube à ondes progressives et dont l'autre extrémité est raccordée à la borne positive d'une source de tension de libération (4) ou à la borne négative d'une source de tension de blocage (5), que pour la commande des deux circuits série formés de transistors à effet de champ de puissance, il est prévu un transformateur toroïdal individuel (13, 14), qui possède un enroulement séparé sur le côté secondaire pour chaque étage à transistor à effet de champ de puissance et dont le côté primaire est chargé par des impulsions unipolaires a haute fréquence de telle sorte que le transformateur toroïdal (13) associé au circuit série des transistors à effet de champ utilisés pour la libération et l'autre transformateur toroïdal (14) reçoivent, le premier respectivement pendant la durée des impulsions de commande de grille et le second respectivement pendant la durée des pauses entre les impulsions de commande de grille, une suite d'impulsions bipolaires identiques de tension à haute fréquence, qui placent à l'état conducteur les transistors à effet de champ du circuit série respectivement chargé, qu'au début d'une suite d'impulsions de tension à haute fréquence, la première impulsion de cette suite charge la capacité d'entrée des transistors à effet de champ du circuit série respectivement chargé et que, pour chaque transistor à effet de champ, il est prévu un circuit de décharge RC, dimensionné spécialement, qui comporte des transistors et décharge la capacité d'entrée de telle sorte que les transistors à effet de champ respectifs sont encore conducteurs lors de l'arrivée de l'impulsion respective de tension à haute fréquence immédiatement suivante.

2. Modulateur d'impulsions de grille suivant la revendication 1, caractérisé par le fait que, lors de la commutation de la tension de libération ($U_{10}$) à la tension de blocage ($U_{20}$) et inversement, respectivement la dernière impulsion à haute fréquence, qui arrive avant l'opération de commutation, pour la suite de transistors (7 à 9 ou 10 à 12), qui est respectivement encore interconnectée, est supprimée.

3. Modulateur d'impulsions de grille suivant la revendication 1 ou 2, caractérisé par le fait que sur le côté primaire des deux transformateurs toroïdaux (13, 14), les impulsions à haute fréquence sont transmises respectivement par l'intermédiaire d'un circuit amplificateur à transistors (24, 25, 28, 29, 32 ou 26, 27, 30, 31, 33), qui possède, dans le circuit de son enroulement primaire, en série avec la voie d'interconnexion directe d'un transistor final à effet de champ (32, 33) commandé par ce circuit amplificateur à transistors, une combinaison RC (34, 35), qui veille à ce que respectivement seule la première impulsion à haute fréquence, transmise après une opération de commutation de la pause entre impulsion à l'impulsion ou de l'impulsion à la pause entre impulsions, est transmise avec une amplitude maximale au circuit série respectif à transistors (7, 8, 9 ou 10, 11, 12).

4. Modulateur d'impulsions de grille selon la revendication 3, caractérisé en ce que dans le circuit amplificateur à transistors (26, 27, 30, 31, 33), qui sert à transmettre la tension de blocage ($U_{20}$), en parallèle avec la combinaison RC (35) est branchée la voie drain-source d'un autre transistor à effet de champ (26), dont l'électrode de grille est interconnectée à l'électrode de grille du transistor final à effet de champ, qui est associé au circuit amplificateur à transistors (24, 25, 28, 29, 32) utilisé pour transmettre la tension de libération ($U_{20}$).

5. Modulateur d'impulsions de grille suivant l'une des revendications précédentes, caractérisé par le fait que les deux transformateurs toroïdaux (13, 14) sont raccordés à une tresse à haute tension.

6. Modulateur d'impulsions de grille suivant l'une des revendications précédentes, caractérisé par son montage dans un cadre métallique, qui agit à la manière d'une cage de Faraday et est rempli d'un liquide isolant.

7. Modulateur d'impulsions de grille suivant l'une des revendications précédentes, caractérisé par le fait qu'un dispositif de dérivation des surtensions est monté directement sur les bornes de la grille et de la cathode du tube à ondes progressives.

8. Modulateur d'impulsions de grille suivant l'une des revendications précédentes, caractérisé par le fait, qu'une ou plusieurs résistances (49 à 56) de faible valeur ohmique sont branchées dans chacune des deux chaînes de transistors (7 à 9, 10 à 12), pour limiter le courant.

9. Modulateur d'impulsions de grille suivant l'une des revendications précédentes, caractérisé par le fait qu'un dispositif de dérivation des surtensions (75) est monté à la sortie (16) du modulateur de manière à fournir une protection vis-à-vis de claquage du tube à ondes progressives.

10. Modulateur d'impulsions de grille suivant l'une des revendications précédentes, caractérisé par le fait que pour la répartition uniforme de la tension de blocage entre les différents transistors (7 à 12) des chaînes de transistors, il est prévu un circuit série constitué par un redresseur rapide (57 à 62) et par une ou plusieurs varistances (63 à 74) et branché en parallèle avec la voie drain-source de chaque transistor.

## Claims

1. Grid pulse modulator for a high-power travelling wave tube provided with a control grid, the tube current of which - controlled via a pulse-controlled switching device - is alternately released by means of a gating voltage which is positive compared with the cathode potential and is applied to the control grid during the high-frequency pulse amplification and is blocked by means of a blocking voltage which is negative compared with the cathode potential and is also applied to the control grid during the pulse intervals, characterized in that the switching device exhibits, both for connecting through the gating voltage ($U_{10}$) and the blocking voltage ($U_{20}$), in each case a series circuit of several power field-effect transistors (7, 8, 9 and 10, 11, 12 respectively), one end of which is in each case connected to the grid connection (16) of the travelling-wave tube and the other end of which is connected to the positive connection of a gating voltage source (4) or to the negative connection of a blocking voltage source (5), respectively, in that for driving each of the two power field effect transistor series circuits, a separate toroidal core transformer (13, 14) is provided which exhibits a separate winding for each power field-effect transistor stage on the secondary side and to the primary side of which unipolar high-frequency pulses are applied in such a manner that the toroidal core transformer (13) associated with the series circuit of the field-effect transistors responsible for the keying with these in each case for the duration of the grid gating pulses and the other toroidal core transformer (14) receives in each case for the duration of the grid pulse intervals a chain of similar unipolar high-frequency voltage pulses which place the field-effect transistors of the series circuit to which they are in each case applied into the conductive state, in that at the beginning of a high-frequency voltage pulse chain, the first pulse of these charges up the input capacitance of the field-effect transistors of the series circuit to which they are in each case applied and in that at each field-effect transistor a specially dimensioned RC discharge circuit with transistors is provided which slowly discharges the input capacitance in such a manner that the respective field-effect transistors are still conductive when the respective next high frequency voltage pulse arrives.

2. Grid pulse modulator according to Claim 1, characterized in that on switch-over from the gating voltage ($U_{10}$) to the blocking voltage ($U_{20}$) and conversely, in each case the last high-frequency pulse arriving before the switching-over process is suppressed for the transistor chain in each case still switched through (7 to 9 or 10 to 12, respectively).

3. Grid pulse modulator according to Claim 1 or 2, characterized in that on the primary side of the two toroidal core transformers (13, 14), the high-frequency pulses are in each case conducted via a transistor amplifier circuit (24, 25, 28, 29, 32 or 26, 27, 30, 31, 33 respectively), which exhibits in the primary winding circuit, in series with the conduction path of a field-effect output transistor (32, 33) driven by this transistor amplifier circuit, an RC combination (34, 35) which ensures that in each case only the first high-frequency pulse transmitted after a switching-over process from pulse interval to pulse or from pulse to pulse interval, respectively, is applied with a maximum amplitude to the respective series transistor circuit (7, 8, 9 or 10, 11, 12 respectively).

4. Grid pulse modulator according to Claim 3, characterized in that in the transistor amplifier circuit (26, 27, 30, 31, 33) responsible for switching-through the blocking voltage ($U_{20}$), in parallel with the RC combination (35), the drain-source path of a further field effect transistor (36) is located, the gate electrode of which is connected together with the gate electrode of the field-effect output transistor which belongs to the transistor amplifier circuit (24, 25, 28, 29, 32) for switching-through the gating voltage ($U_{20}$).

5. Grid pulse modulator according to one of the preceding claims, characterized in that the two toroidal core transformers (13, 14) are wound with high-voltage litz-wire.

6. Grid pulse modulator according to one of the preceding claims, characterized by being accommodated in a metal frame acting as a Faraday cage, which is filled with insulating fluid.

7. Grid pulse modulator according to one of the preceding claims, characterized in that an overvoltage arrester is arranged directly at the grid and cathode connections of the travelling-wave tube.

8. Grid pulse modulator according to one of the preceding claims, characterized in that one or several low-impedance resistors (49 to 56) are inserted in each of the two transistor chains (7 to 9, 10 to 12).

9. Grid pulse modulator according to one of the preceding claims, characterized in that an overvoltage arrester (75) is arranged at the modulator output (16) as a safety measure against flashovers of the travelling-wave tube.

10. Grid pulse modulator according to one of the preceding claims, characterized in that, for the uniform distribution of the blocking voltage to the individual transistors (7 to 12) of the transistor chains, a series circuit consisting of a fast rectifier (57 to 62) and one or several varistors (63 to 74) is provided in parallel with the drain-source path of each transistor.

FIG 1

## FIG 2a

FIG 2b